(19) Europäisches Patentamt
European Patent Office
Office européen des brevets

(11) EP 0 734 023 B1

(12) **FASCICULE DE BREVET EUROPEEN**

(45) Date de publication et mention de la délivrance du brevet:
**21.01.1998 Bulletin 1998/04**

(51) Int Cl.⁶: **G11C 7/00**, G11C 16/06

(21) Numéro de dépôt: **96400576.3**

(22) Date de dépôt: **19.03.1996**

(54) **Procédé de protection en écriture d'une mémoire en circuit intégré et circuit intégré correspondant**

Schreibschutzverfahren für eine integrierte Speicher und entsprechende integrierte Schaltung

Integrated circuit memory write protection method and corresponding integrated circuit

(84) Etats contractants désignés:
**DE FR GB IT**

(30) Priorité: **21.03.1995 FR 9503294**

(43) Date de publication de la demande:
**25.09.1996 Bulletin 1996/39**

(73) Titulaire: **SGS-THOMSON MICROELECTRONICS S.A.**
**94250 Gentilly (FR)**

(72) Inventeurs:
• **Sourgen, Laurent**
**94230 Cachan (FR)**
• **Wuidart, Sylvie**
**94230 Cachan (FR)**

(74) Mandataire: **Schmit, Christian Norbert Marie**
**Cabinet BALLOT-SCHMIT,**
**16, avenue du Pont Royal**
**94230 Cachan (FR)**

(56) Documents cités:
**EP-A- 0 368 727**

**Description**

La présente invention a pour objet un procédé pour améliorer la protection en écriture d'une mémoire en circuit intégré. Elle concerne également un circuit intégré mettant en oeuvre un tel procédé.

Elle s'applique en particulier aux cartes à circuits intégrés ou cartes à microcircuits, principalement dans un domaine d'application où des informations sont écrites au cours de l'utilisation de ces cartes. Ce sont par exemple les cartes prépayées jetables, les cartes prépayées rechargeables, où les cartes bancaires, dans lesquelles des informations sont notamment écrites (par un lecteur de cartes) qui rendent compte du solde avant et après chaque opération.

L'opération d'écriture ne doit pas pouvoir être perturbée ou détournée de quelque manière que ce soit. Cet impératif se comprend très bien dans l'exemple de l'application bancaire : on ne peut pas permettre que l'écriture d'un solde puisse être perturbée, en sorte que le solde lu soit toujours positif par exemple.

L'opération d'écriture consiste à soumettre des cellules mémoire à une grandeur physique provoquant un changement d'état de ces cellules : champ électrique, magnétique ou autres, fonction de la technologie mémoire.

Par exemple, l'écriture des mémoires non volatiles comprend l'application d'une haute tension d'écriture nettement supérieure à la tension d'alimentation logique de la mémoire, sur au moins une électrode d'une cellule, selon la technologie envisagée.

En particulier, la programmation d'une cellule de mémoire $E^2PROM$ nécessite l'application d'une haute tension d'écriture entre la grille et le drain de la cellule, pour obtenir l'effet Fowler Nordheim de migrations de charges électriques vers la grille flottante de la cellule.

Dans l'invention, on a découvert qu'il était possible de perturber le contenu d'une mémoire d'une manière particulière, en agissant au moment d'une opération d'écriture.

En effet, on a découvert un moment précis du cycle d'écriture où l'état de la cellule mémoire bascule. Pour une cellule modifiable électriquement, par exemple une cellule $E^2prom$, c'est le moment où le phénomène physique de migration des charges électriques se produit avec le plus d'intensité. Et on a pu mettre en évidence que ce moment est toujours court par rapport à la durée totale du cycle d'écriture, ceci se produisant pour tout type de mémoire modifiable.

On a alors découvert qu'en perturbant d'une manière ou d'une autre la grandeur physique d'écriture pendant ce moment très court, on pouvait modifier substantiellement le comportement de la cellule mémoire, notamment en rendant la lecture d'un "0" ou d'un "1" incertaine, sans qu'aucun des capteurs de sécurité habituellement utilisés pour vérifier la normalité des conditions externes de fonctionnement du circuit ait pu détecter une quelconque anomalie.

On peut imaginer qu'un fraudeur avisé pourrait donc arriver à déterminer ce moment critique de l'application de la grandeur physique d'écriture de la mémoire, pendant lequel une variation brutale et momentanée de cette grandeur entraînerait une modification substantielle du comportement de la cellule mémoire.

L'invention a pour objet de rendre une telle détermination impossible.

Telle qu'elle est revendiquée, l'invention concerne un procédé pour améliorer la protection d'une opération d'écriture dans une mémoire en circuit intégré, une opération d'écriture de la mémoire comprenant l'application d'une grandeur physique provoquant un changement d'état de la mémoire.

Selon l'invention, le procédé consiste à introduire une durée aléatoire entre la réception par le circuit intégré d'une commande externe d'écriture et l'application interne de cette grandeur physique à la mémoire.

De cette manière, on ne peut plus connaître la courbe d'application de la grandeur physique d'écriture en fonction du temps, ce qui empêche la détermination du moment particulièrement critique vu plus haut.

Pour améliorer la protection de l'opération d'écriture, on prévoit que la durée entre la réception d'une commande d'écriture et l'envoi d'un signal de fin d'exécution de la commande d'écriture est constante.

Dans une variante, cette durée constante est reprogrammable.

Selon une autre caractéristique de l'invention, la durée aléatoire est décomptée par un compteur.

Pour un circuit intégré à microprocesseur, un perfectionnement du procédé consiste en ce que la valeur aléatoire soit décomptée pour partie par ledit microprocesseur, pour partie par le compteur.

L'invention concerne aussi un circuit intégré comprenant une mémoire en circuit intégré, modifiable par l'application d'une grandeur physique d'écriture.

Selon l'invention, le circuit intégré comprend un générateur pseudo-aléatoire pour fournir une valeur aléatoire à chaque commande d'écriture de la dite mémoire et au moins un élément apte à décompter cette valeur, pour retarder de manière aléatoire l'application de ladite grandeur physique, par rapport à la reception par le circuit intégré de ladite commande externe d'écriture.

D'autres caractéristiques et avantages de l'invention sont présentés dans la description suivante, faite à titre indicatif et non limitatif, en référence aux dessins annexés dans lesquels :

-   la figure 1 représente une courbe d'application d'une impulsion de tension Ve pour l'écriture de cellules mémoires modifiables électriquement, dans l'état de la technique (courbe a) et selon l'invention (courbe b),

-   la figure 2 est un schéma général d'un circuit. intégré à mémoire non volatile modifiable électriquement, comprenant un dispositif pour la mise en oeuvre du procédé selon l'invention et

- la figure 3 est un autre schéma général d'un circuit intégré à mémoire non volatile modifiable électriquement, comprenant un dispositif pour la mise en oeuvre du procédé selon l'invention.

L'invention concerne les mémoires modifiables par l'application d'une grandeur électrique d'écriture. On a vu que l'homme du métier peut déterminer un moment critique du cycle d'application de la grandeur physique d'écriture sur des cellules mémoires, pendant lequel l'état de ces cellules mémoires bascule. Ce moment est toujours court devant la durée du cycle d'écriture, quelle que soit la technologie mémoire envisagée.

Dans le cas particulier d'une mémoire modifiable électriquement, la grandeur physique appliquée est plus particulièrement une impulsion de tension.

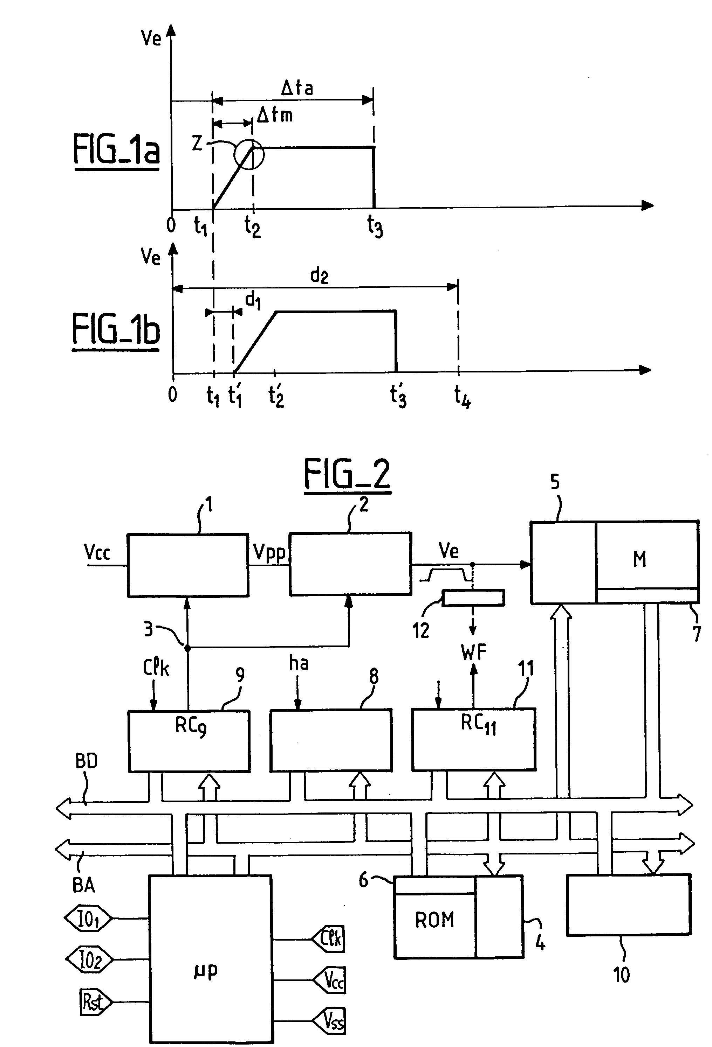

La figure 1 représente ainsi les courbes (a) et (b) d'application en fonction du temps d'une impulsion de tension d'écriture Ve à des cellules d'une mémoire modifiable électriquement, à partir du moment de réception d'une commande d'écriture, moment référencé 0 sur les deux courbes, selon l'état de la technique (a) et selon le procédé de l'invention (b). On obtient des courbes comparables d'application en fonction du temps pour tout autre type de mémoire modifiable en circuit intégré.

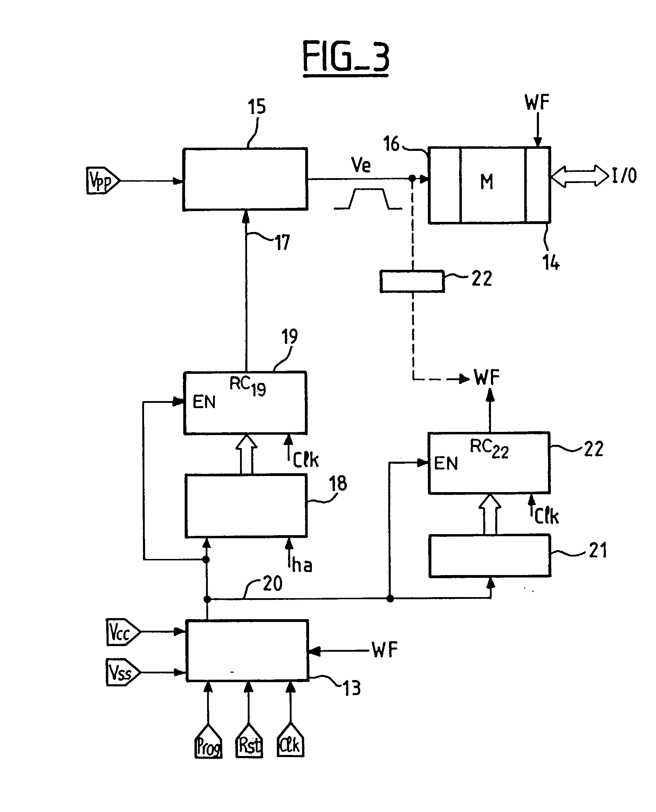

Dans l'état de la technique représenté à la figure 1, courbe a, quand une commande externe d'écriture d'une mémoire modifiable électriquement est reçue par un microprocesseur μp (figure 2) ou une unité de commande 13 (figure 3), il s'écoule une durée tl correspondant au temps de prise en compte et de décodage de la commande par ce microprocesseur ou cette unité de commande pour qu'il ou elle commande l'application de l'impulsion de tension d'écriture Ve au décodeur de la mémoire.

L'impulsion d'écriture se caractérise elle-même par un temps de montée $\Delta tm = t2-t1$ et une largeur $\Delta ta = t3-t1$. Le temps d'application est fonction de la technologie mémoire envisagée : EPROM, E$^2$PROM ou autres, et de l'information à écrire (0 ou 1). Le temps de montée est volontairement contrôlé afin de limiter le stress des cellules mémoires.

L'impulsion d'écriture peut-être formée à partir d'une haute tension générée en interne. Le circuit intégré comprend alors un circuit de génération d'une haute tension Vpp à partir de la tension d'alimentation logique Vcc du circuit intégré qui comprend, comme montré à la figure 2, un élévateur de tension 1 qui délivre une haute tension Vpp et un régulateur de tension 2 qui délivre une impulsion Ve d'écriture de caractéristiques ($\Delta ta$, $\Delta tm$).

Dans certains cas, la haute tension est fournie au circuit intégré, sur une broche d'alimentation Vpp (figure 3). Dans ce cas, le circuit intégré comprend un circuit 15 de commutation et de mise en forme de la haute tension pour appliquer une impulsion d'écriture de caractéristiques ($\Delta ta$,$\Delta tm$) au décodeur de la mémoire.

Mais quels que soient les moyens utilisés pour générer et appliquer l'impulsion d'écriture, la courbe (a) d'application en fonction du temps de cette impulsion et plus généralement, de la grandeur physique d'écriture, est toujours la même d'une commande d'écriture à l'autre : c'est une caractéristique physique du circuit intégré. La connaissance de cette courbe pourrait permettre à un fraudeur avisé d'identifier le moment critique précis Z de l'application de l'impulsion d'écriture sur les cellules mémoires, pendant lequel une variation quelconque d'un des paramètres de fonctionnement du circuit (tension, température, fréquence) peut entraîner une modification substantielle de l'état des cellules soumises à l'impulsion d'écriture.

Dans l'invention, on cherche à empêcher une telle détermination, pour éviter toute fraude.

Selon l'invention, quand une commande externe d'écriture est reçue, on introduit une durée aléatoire entre la réception de cette commande et l'application de l'impulsion d'écriture à la mémoire. Dans l'exemple de la courbe (b), représentée sur la figure 1, on a ainsi introduit une durée aléatoire d1 entre la prise en compte de la commande qui est faite à t1 et l'application de l'impulsion qui ne débute qu'à t1' (d1 = t1'-t1).

Les caractéristique propres $\Delta ta$ et $\Delta tm$ de l'impulsion restent inchangées. Si t2' est le temps au bout duquel l'impulsion atteint son niveau haut et t3' le temps où l'impulsion se termine (front descendant dans l'exemple), on a ainsi :

$$t3'-t1' = \Delta ta$$

et

$$t2'-t1' = \Delta tm.$$

La durée aléatoire d1, pour être efficace, doit pouvoir prendre une valeur dans un intervalle de temps suffisamment grand devant la durée de la période critique. Mais cet intervalle ne sera pas choisi trop grand devant la largeur $\Delta ta$ de l'impulsion d'écriture, pour ne pas trop ralentir l'opération d'écriture.

L'opération d'écriture est terminée sur le front descendant de l'impulsion, soit en t3'= t1+d1+$\Delta ta$ sur la courbe (b).

De préférence, pour mieux sécuriser le mode de protection selon l'invention, on choisit d'avoir une durée totale constante d2 entre la réception d'une commande d'écriture et l'envoi d'un signal de fin d'exécution de la commande, pour masquer l'aspect aléatoire selon l'invention. Dans ce cas le signal de fin d'exécution de la commande d'écriture ne correspond plus à la détection du front descendant de l'impulsion, mais à l'expiration d'un délai supplémentaire égal à d2-t1-$\Delta ta$, à partir de la réception d'une commande externe (référencée à 0). Sur la figure 1, on voit ainsi que la courbe (a) initiale se retrouve en (b) avec une position aléatoire dans une fenêtre de temps de durée d2.

Ce qui importe en pratique, c'est de choisir un retard aléatoire d1 grand devant la durée du moment critique Z et un allongement de la durée totale de l'écriture petit devant la durée minimum obligatoire de l'écriture qui est égale au temps nécessaire de prise en compte et de décodage de la commande externe (t1), ajouté à la largeur de l'impulsion d'écriture ($\Delta$ta).

Avec le procédé de l'invention, on rend ainsi impossible ou au moins très difficile la détermination du moment critique Z où l'écriture dans une mémoire est particulièrement sensible aux paramètres de fonctionnement.

Un exemple d'application à un circuit intégré à mémoire du type non volatile modifiable électriquement et comprenant un circuit de génération interne de l'impulsion d'écriture est représenté sur la figure 2.

Dans cet exemple, le circuit intégré comprend un microprocesseur µP, une mémoire ROM et une mémoire non volatile M. Ces différentes ressources (non exhaustives) sont ici toutes connectées au bus d'adresse BA et au bus de données BD contrôlés par le microprocesseur. Plus particulièrement, le bus d'adresse arrive sur le décodeur 4 de la mémoire ROM et sur le décodeur 5 de la mémoire non volatile M. Le bus de données est appliqué à l'étage d'entrée 6 de la mémoire ROM (accessible en lecture seulement) et à l'étage d'entrée-sortie 7 de la mémoire non volatile M (accessible en lecture-écriture).

Par ailleurs le microprocesseur reçoit les signaux d'interface externe du circuit intégré, soit dans l'exemple représenté : la tension logique Vcc, la masse électrique Vss, un signal d'horloge Clk, un signal de réinitialisation du circuit intégré Rst et deux signaux d'entrée-sortie série de données $IO_1$ et $IO_2$.

Le circuit intégré comprend aussi un circuit de génération interne de la haute tension Vpp nécessaire à l'écriture de la mémoire non volatile. Ce circuit de génération comprend de manière connue et simplifiée, un élévateur de tension 1 (pompe de charges) qui délivre une haute tension Vpp et un circuit 2 de régulation qui délivre une impulsion d'écriture Ve de largeur $\Delta$ta et de temps de montée $\Delta$tm. Ces deux circuits sont activés sur réception d'un signal de commande 3. Dans la suite on parle d'un circuit de génération de l'impulsion d'écriture.

L'impulsion d'écriture Ve est appliquée aux cellules de la mémoire non volatile M par le décodeur d'adresse 5.

Selon le procédé de l'invention, une durée aléatoire dl est utilisée pour retarder l'activation du signal de commande 3 du circuit de génération de l'impulsion d'écriture.

Dans un premier exemple de mise en oeuvre du procédé de l'invention, le circuit intégré comprend un générateur pseudo-aléatoire 8 pour initialiser un compteur 9 dont une sortie $RC_9$ est utilisée pour délivrer le signal de commande 3 du circuit de génération de l'impulsion d'écriture.

En pratique, la sortie $RC_9$ représente la retenue du compteur. L'horloge Clk est appliquée au compteur 9. Une horloge ha générée en interne est appliquée au générateur pseudo-aléatoire 8. Cette horloge est de préférence astable.

Quand le microprocesseur a reçu une instruction d'écriture de la mémoire non volatile sur les signaux d'entrée-sortie $IO_1$ et $IO_2$, et décodé cette instruction au bout d'un temps t1, il va lire une valeur aléatoire dans le générateur pseudo-aléatoire 8 pour initialiser et activer le compteur 9. La valeur aléatoire est décomptée à la cadence de l'horloge Clk. Quand la retenue du compteur 9 passe à 1, la sortie $RC_9$ correspondante active le circuit de génération de l'impulsion d'écriture (1 et 2).

Pour la mise en oeuvre du procédé préféré selon lequel une opération d'écriture garde malgré tout une durée constante d2, le circuit intégré comprend en outre un élément de mémorisation 10 d'une information relative à la durée constante d2 et un autre compteur 11.

Quand le microprocesseur a décodé une instruction externe d'écriture de la mémoire non volatile reçue sur les signaux d'entrée-sortie $IO_1$ et $IO_2$, au bout du temps t1, il va lire l'élément de mémorisation 10 pour initialiser et activer le compteur 11. La valeur représentative de la durée constante d2 est décomptée dans ce compteur, à la cadence de l'horloge Clk. Quand la retenue du compteur 11 passe à 1, la sortie $RC_{11}$ correspondante est utilisée pour délivrer le signal de fin d'exécution de l'opération d'écriture WF, vers le microprocesseur notamment, qui peut alors renvoyer un message de fin d'exécution sur les signaux $IO_1$ et $IO_2$.

D'autres modes de fonctionnement sont possibles. Par exemple, on peut imaginer commander l'initialisation du compteur 11 sur détection du front descendant de l'impulsion d'écriture, avec une valeur calculée à chaque fois par soustraction à la durée constante d2, de la durée aléatoire décomptée d1, et des durées t1 et $\Delta$ta.

En pratique, l'élément de mémorisation 10 peutêtre un élément de la mémoire ROM ou une batterie de fusible. Il est de préférence programmable une seule fois, mais on peut imaginer pour certaines applications qu'il soit reprogrammable, moyennant des sécurités d'accès. Par exemple, on peut imaginer que pour les cartes prépayées rechargeables, cette durée d2 soit modifiée à chaque rechargement d'unités.

Pour améliorer la protection, on peut encore prévoir que cette durée d2 est déterminée pour un circuit donné, et peut varier d'un circuit à l'autre dans une fourchette de valeurs.

Dans le cas où l'on choisit de ne pas imposer une durée constante d2 pour l'opération d'écriture, le signal de fin d'exécution de l'opération d'écriture WF est délivré de manière habituelle, par un circuit 12 de détection de front descendant représenté en pointillé sur la figure 2.

D'autres variantes de fonctionnement (non représentées) sont possibles, notamment en utilisant des boucles de comptage du microprocesseur, en combinaison ou non avec les compteurs 9 et 11 (variantes de structure).

Dans une première variante, les compteurs 9 et 11 ne sont pas prévus. Le générateur pseudo-aléatoire 8 est utilisé par le microprocesseur pour initialiser une boucle de comptage aléatoire 8. L'élément de mémorisation 10 est utilisé par le microprocesseur pour initialiser une boucle de comptage d'une valeur représentative de la durée d2, si l'option de durée constante est choisie.

Dans une autre variante, les compteurs 9 et 11 sont utilisés comme vu plus haut, mais on prévoit en plus de retarder artificiellement et de manière aléatoire la prise en compte et le décodage d'une commande externe d'écriture par le microprocesseur. Pour cela on prévoit, avant l'initialisation du compteur 9, que le microprocesseur va lire le générateur pseudo-aléatoire 8 pour initialiser une boucle de comptage logiciel. De cette manière, on obtient une première durée aléatoire décomptée par le microprocesseur lui-même, puis une deuxième durée aléatoire décomptée par le compteur 9. On obtient de cette manière une protection optimum. On peut prévoir d'interroger deux fois le générateur pseudo-aléatoire, une fois pour initialiser la boucle de comptage, une fois pour initialiser le compteur 9. Le générateur devra alors être dimensionné pour que la somme des deux durées aléatoire ne dépasse pas une durée maximum. On peut aussi prévoir de n'interroger qu'une seule fois le générateur pseudo-aléatoire, à charge pour le microprocesseur d'en déduire une valeur pour la boucle de comptage et une valeur pour le compteur 9. En fait, tout se passe dans cette variante comme si la durée aléatoire dl sur la courbe (b) de la figure 1 était pour partie décomptée par le microprocesseur lui-même (c'est à dire par logiciel) et pour partie décomptée par un compteur (c'est à dire par un élément matériel).

Dans l'exemple représenté, les éléments 8, 9, 10 et 11 servant à la mise en oeuvre du procédé de l'invention sont tous disposés sur les bus d'adresse et de données du circuit intégré. Selon la variante de fonctionnement retenue, on peut prévoir que le compteur 9 ou 11 soit uniquement accessible par l'élément qui l'initialise (générateur pseudo-aléatoire 8 ou élément de mémorisation 10).

Un autre exemple d'application du procédé de l'invention à un circuit intégré, dans lequel la haute tension d'alimentation Vpp est fournie sur une broche externe, est représenté à la figure 3. On notera que pour ceux des éléments de la figure 2 qui ont des références non numériques et qui se retrouvent à la figure 3, les mêmes références ont été adoptées.

Le circuit intégré comprend un circuit 13 de commande de type séquenceur d'instructions, comprenant un décodeur des signaux de commande et un compteur d'adresse pour adresser une mémoire non volatile M. L'étage d'entrée-sortie 14 de la mémoire non volatile est relié à un port série d'entrée-sortie de données I/O.

Les signaux de commande reçus par le circuit de commande 13 sont généralement un signal de réinitialisation du circuit intégré Rst, un signal d'horloge Clk et un signal de commande d'écriture Prog.

Le circuit intégré reçoit par ailleurs une tension d'alimentation logique Vcc et la masse électrique Vss, appliqués notamment au circuit de commande 13 et la haute tension d'alimentation Vpp nécessaire à l'écriture de la mémoire non volatile.

Cette haute tension d'alimentation Vpp est appliquée à un circuit 15 de commutation de cette haute tension sur le décodeur 16 de la mémoire, avec mise en forme en une impulsion d'écriture Ve de caractéristiques $\Delta tm$ et $\Delta ta$. Ce circuit de commutation est activé sur réception d'un signal de commande 17.

Pour mettre en oeuvre le procédé de l'invention, selon lequel ce signal de commande 17 est retardé d'une durée aléatoire d1 après la prise en compte d'une commande externe d'écriture (séquence particulière des niveaux logiques des signaux de commande), le circuit intégré comprend un générateur pseudo-aléatoire 18 couplé à un compteur 19. Une sortie $RC_{19}$ du compteur, la retenue dans l'exemple, est utilisée comme signal de commande 17 du circuit de commutation 15. L'horloge Clk est appliquée au compteur 19. Une horloge ha générée en interne est appliquée au générateur pseudo-aléatoire 18. Cette horloge est de préférence astable.

Quand le circuit de commande 13 a pris en compte et décodé une commande externe d'écriture de la mémoire non volatile (au bout de t1), il active le générateur pseudo-aléatoire 18 et le compteur 19, pour initialiser ce dernier avec une valeur sortie par le générateur (signal de commande 20 sur la figure 3). Cette valeur est décomptée à la cadence de l'horloge Clk appliquée au compteur. Quand cette valeur est totalement décomptée, la retenue $RC_{19}$ du compteur passe à 1, ce qui active le circuit de commutation 15.

Pour la mise en oeuvre du procédé de l'invention, selon lequel une opération d'écriture garde une durée constante d2, le circuit intégré comprend en outre un élément de mémorisation 21, contenant une information correspondant à la durée d2 déterminée pour ledit circuit intégré, et un compteur 22 dont une sortie $RC_{22}$ est utilisée comme signal de fin d'exécution de l'opération d'écriture WF (dans l'exemple, $RC_{22}$ est la retenue du compteur). Le signal de commande 20 sert alors à initialiser le compteur 22 avec l'information mémorisée dans l'élément de mémorisation 21, et à valider le décomptage qui s'opère alors à la cadence de l'horloge Clk. Le signal WF est appliqué au circuit de commande et à l'étage d'entrée-sortie 14 de la mémoire (pour la mettre en haute impédance).

En pratique, l'élément de mémorisation 21 peut être un élément de la mémoire ROM ou une batterie de fusible, comme l'élément de mémorisation 10 vu en relation avec la figure 2. Comme on l'a vu à cette occasion, il peut être programmable une seule fois, ou reprogrammable, moyennant des sécurités d'accès.

Si on ne retient pas l'option de durée constante d2 pour l'opération d'écriture, le signal de fin d'exécution de l'opération d'écriture WF est délivré de manière habituelle, par un circuit 22 de détection de front descendant représenté en pointillé sur la figure 3.

Dans les deux exemples de circuit intégré détaillés ci-dessus, on a retenu un mode d'accès série aux données. Ce choix est sans influence sur la mise en oeuvre du procédé selon l'invention qui s'applique tout aussi bien à des circuits intégrés avec accès parallèle aux données, ainsi qu'à tout type de mémoire modifiable.

**Revendications**

1. Procédé de protection d'une opération d'écriture d'une mémoire (M) en circuit intégré, une opération d'écriture d'une cellule mémoire comprenant l'application d'une grandeur physique apte à provoquer un changement d'état de la cellule, caractérisé en ce qu'il consiste à introduire une durée aléatoire (d1) entre la réception par le circuit intégré d'une commande externe d'écriture et l'application de ladite grandeur physique.

2. Procédé selon la revendication 1, caractérisé en ce que la durée entre la réception d'une commande externe d'écriture et l'envoi d'un signal de fin d'exécution de la commande d'écriture (WF) a une valeur constante (d2) déterminée.

3. Procédé selon la revendication 2, caractérisé en ce que la valeur constante (d2) est déterminée pour chaque circuit et programmée dans un élément de mémorisation (10,21).

4. Procédé selon la revendication 3, caractérisé en ce que la valeur constante (d2) est reprogrammable.

5. Procédé selon l'une quelconque des revendications précédentes, caractérisé en ce qu'il consiste à faire décompter la durée aléatoire (d1) par un compteur (9,19).

6. Procédé selon l'une quelconque des revendications 1 à 4, pour un circuit intégré à microprocesseur (μp), caractérisé en ce qu'il consiste à faire décompter la durée aléatoire (d1) par ledit microprocesseur.

7. Procédé selon l'une quelconque des revendications 1 à 4, pour un circuit intégré à microprocesseur (μp), caractérisé en ce qu'à chaque commande externe d'écriture, un générateur pseudo-aléatoire (8) fournit une valeur aléatoire à décompter pour partie par ledit microprocesseur, pour partie par un compteur (9).

8. Procédé selon l'une quelconque des revendications 1 à 4, pour un circuit intégré à microprocesseur (μp), caractérisé en ce qu'à chaque commande externe d'écriture, un générateur pseudo-aléatoire (8) fournit une première valeur aléatoire à décompter par ledit microprocesseur et une deuxième valeur aléatoire à décompter par un compteur (9).

9. Circuit intégré comprenant une mémoire modifiable par application d'une grandeur physique d'écriture (Ve), caractérisé en ce qu'il comprend un générateur pseudo-aléatoire (8,18) pour fournir une valeur aléatoire (d1) à chaque commande d'écriture de ladite mémoire et au moins un élément apte à décompter cette valeur pour retarder de manière aléatoire l'application de ladite grandeur physique, par rapport à la reception par le circuit intégré de ladite commande externe d'écriture.

10. Circuit intégré selon la revendication 9, caractérisé en ce qu'il comprend un compteur (9,19) pour décompter ladite valeur aléatoire.

11. Circuit intégré à microprocesseur (μp) selon la revendication 9, caractérisé en ce que ledit microprocesseur initialise une boucle de comptage pour décompter ladite valeur aléatoire (d1).

12. Circuit intégré à microprocesseur (μp) selon la revendication 9, caractérisé en ce qu'il comprend un compteur (9), et en ce que ladite valeur aléatoire est décomptée pour partie par le microprocesseur dans une boucle de comptage et pour partie par le compteur.

13. Circuit intégré à microprocesseur (μp) selon la revendication 9, caractérisé en ce qu'il comprend un compteur (9), et en ce que le générateur pseudo-aléatoire fournit une première valeur à décompter par le microprocesseur dans une boucle de comptage et une deuxième valeur à décompter par le compteur.

14. Circuit intégré selon l'une quelconque des revendications précédentes, caractérisé en ce qu'il comprend un élément de mémorisation (10,21) d'une valeur représentative d'une durée constante (d2) d'exécution de la commande d'écriture.

15. Circuit intégré à microprocesseur (μp) selon la revendication 14, caractérisé en ce que ladite valeur constante est décomptée par le microprocesseur dans une boucle de comptage.

16. Circuit intégré selon la revendication 14, caractérisé en ce qu'il comprend un compteur (11,22) pour décompter ladite valeur constante.

17. Circuit intégré selon l'une quelconque des revendications 14 à 16, caractérisé en ce que l'élément de mémorisation (10,21) de ladite valeur constante est reprogrammable.

18. Circuit intégré selon l'une quelconque des revendications 9 à 17, caractérisé en ce que la mémoire est du type non volatile modifiable électriquement.

19. Carte à microcircuits, caractérisée en ce qu'elle comprend un circuit intégré selon l'une quelconque des revendications 9 à 18.

**Patentansprüche**

1. Verfahren zum Schutz einer Schreiboperation bei einem Speicher (M) eines integrierten Schaltkreises, wobei eine Schreiboperation in einer Speicherzelle das Anlegen einer physikalischen Größe beinhaltet, die geeignet ist, eine Änderung des Zustandes der Zelle hervorzurufen, dadurch gekennzeichnet, daß es darin besteht, eine zufällige Dauer (d1) zwischen Empfang eines Schreibbefehls von außen durch den integrierten Schaltkreis und das Anlegen der physikalischen Größe einzuführen.

2. Verfahren nach Anspruch 1, dadurch gekennzeichnet, daß die Dauer zwischen dem Empfang eines Schreibbefehls von außen und dem Abschicken eines Endsignals der Ausführung des Schreibbefehls (WF) einen vorgegebenen festen Wert (d2) hat.

3. Verfahren nach Anspruch 2, dadurch gekennzeichnet, daß der konstante Wert (d2) für den Schaltkreis festgelegt ist und in einem Speicherelement (10, 21) programmiert ist.

4. Verfahren nach Anspruch 3, dadurch gekennzeichnet, daß der konstante Wert (d2) überschreibbar ist.

5. Verfahren nach einem der vorangehenden Ansprüche, dadurch gekennzeichnet, daß es darin besteht, die zufällige Dauer (d1) durch einen Zähler (9, 19) abzählen zu lassen.

6. Verfahren nach einem der Ansprüche 1 bis 4 für einen integrierten Schaltkreis mit Mikroprozessor (µp), dadurch gekennzeichnet, daß es darin besteht, die zufällige Dauer (d1) durch den Mikroprozessor abzählen zu lassen.

7. Verfahren nach einem der Ansprüche 1 bis 4 für einen integrierten Schaltkreis mit Mikroprozessor (µp), dadurch gekennzeichnet, daß bei jedem Schreibbefehl von außen ein Pseudozufallsgenerator (8) einen Zufallswert ausgibt, der zum Teil durch den Mikroprozessor, zum Teil durch einen Zähler (9) abzuzählen ist.

8. Verfahren nach einem der Ansprüche 1 bis 4 für einen integrierten Schaltkreis mit Mikroprozessor (µp), dadurch gekennzeichnet, daß bei jedem Schreibbefehl von außen ein Pseudozufallsgenerator (8) einen ersten Zufallswert, der durch den Mikroprozessor abzuzählen ist, und einen zweiten Zufallswert, der durch einen Zähler (9) abzuzählen ist, ausgibt.

9. Integrierter Schaltkreis mit einem durch Anlegen einer physikalischen Schreibgröße (Ve) modifizierbaren Speicher, dadurch gekennzeichnet, daß er einen Pseudozufallsgenerator (8, 18), um einen Zufallewert (d1) bei jedem Befehl zum Schreiben in dem Speicher ausgibt, und wenigstens ein Element umfaßt, das sich zum Abzählen dieses Wertes eignet, um in zufälliger Weise das Anlegen der genannten physikalischen Größe in bezug auf den Empfang des Schreibbefehls von außen durch den integrierten Schaltkreis zu verzögern.

10. Integrierter Schaltkreis nach Anspruch 9, dadurch gekennzeichnet, daß er einen Zähler (9, 19) zum Abzählen des Zufallswertes umfaßt.

11. Integrierter Schaltkreis mit Mikroprozessor (µp) nach Anspruch 9, dadurch gekennzeichnet, daß der Mikroprozessor eine Zählschleife zum Abzählen des Zufallswertes (d1) initialisiert.

12. Integrierter Schaltkreis mit Mikroprozessor (µp) nach Anspruch 9, dadurch gekennzeichnet, daß er einen Zähler (9) umfaßt und daß der Zufallswert teilweise durch den Mikroprozessor in einer Zählschleife und teilweise durch den Zähler abgezählt wird.

13. Integrierter Schaltkreis mit Mikroprozessor (µp) nach Anspruch 9, dadurch gekennzeichnet, daß er einen Zähler (9) umfaßt und daß der Pseudozufallsgenerator einen ersten Wert, der durch den Mikroprozessor in einer Zählschleife abgezählt werden soll, und einen zweiten Wert, der durch den Zähler abgezählt werden soll, ausgibt.

14. Integrierter Schaltkreis nach einem der vorangehenden Ansprüche, dadurch gekennzeichnet, daß er ein Speicherelement (10, 21) für einen Wert umfaßt, der eine konstante Dauer (d2) zur Ausführung des Schreibbefehls darstellt.

15. Integrierter Schaltkreis mit Mikroprozessor (µp) nach Anspruch 14, dadurch gekennzeichnet, daß der konstante Wert durch den Mikroprozessor in einer Zählschleife abgezählt wird.

16. Integrierter Schaltkreis nach Anspruch 14, dadurch gekennzeichnet, daß er einen Zähler (11, 22) zum Abzählen des konstanten Wertes umfaßt.

17. Integrierter Schaltkreis nach einem der Ansprüche 14 bis 16, dadurch gekennzeichnet, daß das Speicherelement (10, 21) für den konstanten Wert wiederbescbreibbar ist.

18. Integrierter Schaltkreis nach einem der Ansprüche 9 bis 17, dadurch gekennzeichnet, daß der Speicher vom elektrisch modifizierbaren, nichtflüchtigen Typ ist.

19. Karte mit Mikrochips, dadurch gekennzeichnet, daß sie einen integrierten Schaltkreis nach einem der Ansprüche 9 bis 18 umfaßt.

## Claims

1. Method of protecting an operation of writing to an integrated circuit memory (M), an operation of writing to a memory cell comprising the application of a physical quantity able to cause a change of state of the cell, characterised in that it consists of introducing a random period (d1) between the reception by the integrated circuit of an external writing command and the application of the said physical quantity,

2. Method according to Claim 1, characterised in that the period between the reception of an external writing command and the sending of a signal for the end of execution of the writing command (WF) has a given constant value (d2).

3. Method according to Claim 2, characterised in that the constant value (d2) is determined for each circuit and programmed in a storage element (10, 21).

4. Method according to Claim 3, characterised in that the constant value (d2) is reprogrammable.

5. Method according to any one of the preceding claims, characterised in that it consists of causing the random period (d1) to be counted down by a counter (9, 19).

6. Method according to any one of Claims 1 to 4, for an integrated circuit with a microprocessor (μp), characterised in that it consists of causing the random period (d1) to be counted down by the said microprocessor.

7. Method according to any one of Claims 1 to 4, for an integrated circuit with a microprocessor (μp), characterised in that, at each external writing command, a pseudo-random generator (8) supplies a random value to be counted down partly by the said microprocessor and partly by a counter (9).

8. Method according to any one of Claims 1 to 4, for an integrated circuit with a microprocessor (μp), characterised in that, at each external writing command, a pseudo-random generator (8) supplies a first random value to be counted down by the said microprocessor and a second random value to be counted down by a counter (9).

9. Integrated circuit comprising a memory which can be modified by the application of a writing physical quantity (Ve), characterised in that it comprises a pseudo-random generator (8, 18) for supplying a random value (d1) at each writing command of the said memory and at least one element able to count down this value in order to delay, in a random fashion, the application of the said physical quantity, with respect to the reception of the said external writing command by the integrated circuit.

10. Integrated circuit according to Claim 9, characterised in that it comprises a counter (9, 19) for counting down the said random value.

11. Integrated circuit with a microprocessor (μp) according to Claim 9, characterised in that the said microprocessor initialises a counting loop for counting down the said random, value (d1).

12. Integrated circuit with a microprocessor (μp) according to Claim 9, characterised in that it comprises a counter (9), and in that the said random value is counted down partly by the microprocessor in a counting loop and partly by the counter.

13. Integrated circuit with a microprocessor (μp) according to Claim 9, characterised in that it comprises a counter (9), and in that the pseudo-random generator supplies a first value to be counted down by the microprocessor in a counting loop and a second value to be counted down by the counter.

14. Integrated circuit according to any one of the preceding claims, characterised in that it comprises an element (10, 21) for storing a value representing a constant period (d2) of execution of the writing command.

15. Integrated circuit with a microprocessor (μp) according to Claim 14, characterised in that the said constant value is counted down by the microprocessor in a counting loop.

16. Integrated circuit according to Claim 14, characterised in that it comprises a counter (11, 22) for counting down the said constant value.

**17.** Integrated circuit according to any one of Claims 14 to 16, characterised in that the element (10, 21) for storing the said constant value is reprogrammable.

**18.** Integrated circuit according to any one of Claims 9 to 17, characterised in that the memory is of the electrically modifiable non-volatile type.

**19.** Microcircuit card, characterised in that it comprises an integrated circuit according to any one of Claims 9 to 18.

FIG_1a

FIG_1b

FIG_2

# FIG_3